# EUROPÄISCHE PATENTSCHRIFT

(11) **EP 3 519 345 B1**
(45) Veröffentlichungstag und Bekanntmachung des Hinweises auf die Patenterteilung: **03.05.2023**
(21) Anmeldenummer: 17777260.5
(22) Anmeldetag: 29.09.2017
(51) Int. Cl.: B67C 3/26, B67C 3/28, F16K 49/00, F16K 37/00, F16K 41/10

(54) **VORRICHTUNG ZUM BEEINFLUSSEN DES VOLUMENSTROMS EINES FÜLLPRODUKTS IN EINER ABFÜLLANLAGE**
DEVICE FOR INFLUENCING THE VOLUME FLOW OF A FILLING PRODUCT IN A FILLING SYSTEM
DISPOSITIF PERMETTANT D'AGIR SUR LE FLUX VOLUMIQUE D'UN PRODUIT DE REMPLISSAGE DANS UNE INSTALLATION DE MISE EN BOUTEILLE

(30) Priorität: 29.09.2016 DE 102016118474
(43) Veröffentlichungstag der Anmeldung: 07.08.2019
(73) Patentinhaber: Krones AG, 93073 Neutraubling (DE)
(72) Erfinder: ANGERER, Florian, 93073 Neutraubling (DE); DOBLINGER, Josef, 93073 Neutraubling (DE)
(74) Vertreter: Nordmeyer, Philipp Werner
(86) Internationale Anmeldenummer: PCT/EP2017/074768
(87) Internationale Veröffentlichungsnummer: WO 2018/060419

(56) Entgegenhaltungen:
- EP-A2- 3 006 392
- WO-A1-01/62059
- WO-A1-2007/012402
- WO-A1-2009/004501
- DE-A1- 19 850 188

## Beschreibung

### Technisches Gebiet

Die vorliegende Erfindung betrifft eine Vorrichtung zum Beeinflussen des Volumenstroms eines Füllprodukts in einer Abfüllanlage zum Befüllen eines Behälters mit einem Füllprodukt, beispielsweise zum Beeinflussen des Volumenstroms des abzufüllenden Getränks beim Befüllen eines Getränkebehälters mit dem Getränk in einer Getränkeabfüllanlage.

### Stand der Technik

In Getränkeabfüllanlagen ist es bekannt, den Volumenstrom des aus einem Füllproduktreservoir zu dem eigentlichen Füllventil strömenden Füllprodukts zu beeinflussen und insbesondere zu steuern oder zu regeln. Hierzu sind Drosselventile bekannt, welche in den Füllproduktweg zwischen das Füllproduktreservoir und den Füllproduktauslass geschaltet werden und mittels welchen der Volumenstrom beeinflusst werden kann.

Beispielsweise ist aus der WO 2014/009362 A2 ein Ventil bekannt, welches als Proportionalventil ausgebildet sein kann und mit welchem der Volumenstrom des Füllprodukts beeinflusst werden kann. Dabei ist es möglich, nicht nur zwischen zwei unterschiedlichen Volumenströmen zu schalten, also zwischen einem ersten Volumenstrom, bei welchem das Ventil vollständig geöffnet ist und einem zweiten Volumenstrom, bei welchem das Ventil vollständig geschlossen ist, sondern das Proportionalventil ermöglicht es, unterschiedliche bzw. beliebig viele unterschiedliche Volumenströme je nach Stellung des Ventilkegels relativ zu dessen Ventilsitz einzustellen. Hierzu ist in dem genannten Proportionalventil ein Aktuator vorgesehen, mittels welchem unterschiedliche Positionen des Ventilkegels gegenüber dem Ventilsitz angefahren werden können und auf diese Weise unterschiedliche Volumenströme eingestellt werden können.

Um mittels des Proportionalventils einen reproduzierbaren Volumenstrom in der Abfüllvorrichtung bereitzustellen, ist eine Ansteuerelektronik vorgesehen, mittels welcher der Aktuator betätigt werden kann und welche dafür sorgt, dass der von einer zentralen Steuerung geforderte Volumenstrom durch das jeweilige individuelle Proportionalventil auch bereitgestellt wird.

In einer Getränkeabfüllanlage ist üblicherweise eine Vielzahl an Abfüllstellen vorgesehen und jeder dieser Abfüllstellen ist ein solches Proportionalventil vorgeschaltet, um den Volumenstrom, welcher schlussendlich in den zu befüllenden Behälter einströmt, den jeweiligen Vorgaben einer zentralen Abfüllsteuerung entsprechend steuern zu können.

Ein kompakter Aufbau des Proportionalventils wird darüber angestrebt, dass der Aktuator und die Steuerungselektronik in einem mit dem Ventilkörper direkt verbundenen Gehäuse angeordnet sind. Entsprechend kann das Proportionalventil in der Getränkeabfüllanlage als kompakte Einheit platziert werden.

Aufgrund der Anordnung von Steuerelektronik und Aktuator in einem sich direkt an den Ventilkörper anschließenden Gehäuse ergibt sich jedoch, dass ein solches kompaktes Proportionalventil nur in Getränkeabfüllanlagen verwendet werden kann, welche für die Kaltabfüllung vorgesehen sind, da ein zu hoher Wärmeeintrag in die Steuerungselektronik die Funktionalität und Dauerhaltbarkeit der Steuerungselektronik negativ beeinflussen kann. Entsprechend ist es in bekannten Vorrichtungen notwendig gewesen, die Steuerelektronik bei Abfüllanlagen, welche für die Durchführung von Abfüllverfahren bei hohen Temperaturen vorgesehen sind, in einem separaten Elektronikkasten unterzubringen, um eine thermische Entkopplung von heißem Ventilkörper und Steuerelektronik bereitzustellen. Entsprechend ließ sich auf diese Weise ein kompakter Aufbau der Proportionalventile und damit der gesamten Getränkeabfüllanlage nicht erreichen.

Die WO 01/62059 A1 beschreibt ein Ventil mit Aktuator zur Anwendung in einer heißen Umgebung. Die DE 198 50 188 A1 beschreibt einen Adapter zur Montage einer Betätigungseinrichtung an einem Ventil. Die EP 3 006 392 A2 beschreibt eine Vorrichtung zum Befüllen eines Behälters mit einem Füllprodukt.

### Darstellung der Erfindung

Entsprechend ist es eine Aufgabe der vorliegenden Erfindung, eine kompakte Vorrichtung zum Beeinflussen des Volumenstroms eines Füllprodukts bereitzustellen, welche auch in Heißabfüllverfahren verwendet werden kann.

Diese Aufgabe wird durch eine Vorrichtung zum Beeinflussen des Volumenstroms in einer Abfüllanlage mit den Merkmalen des Anspruchs 1 gelöst. Vorteilhafte Weiterbildungen ergeben sich aus den Unteransprüchen, der Beschreibung sowie den Figuren.

Entsprechend wird eine Vorrichtung zum Beeinflussen des Volumenstroms eines Füllprodukts in einer Abfüllanlage zum Abfüllen von Füllprodukten vorgeschlagen, umfassend einen Ventilkörper mit einem Ventilsitz und einen relativ zu diesem bewegbaren Ventilkegel, einen Aktuator zum Positionieren des Ventilkegels bezüglich des Ventilsitzes, eine Steuerelektronik zum Ansteuern des Aktuators, sowie ein Gehäuse, welches direkt mit dem Ventilkörper verbunden ist und in welchem der Aktuator und die Steuerelektronik angeordnet sind. Erfindungsgemäß ist eine Einrichtung zum Reduzieren eines Wärmeeintrags in die Steuerelektronik vorgesehen.

Dadurch, dass die Einrichtung zum Reduzieren des Wärmeeintrags in die Steuerelektronik vorgesehen ist, kann die Vorrichtung zum Beeinflussen des Volumenstroms des Füllprodukts, die durch die Aufnahme der Steuerelektronik in dem Gehäuse bereits kompakt ausgebildet ist und welche entsprechend auf die Bereitstellung eines zentralen Elektronikkastens zur Aufnahme der gesamten Steuerelektronik verzichten kann, auch in Heißabfüllverfahren verwendet werden, da der Wärmeeintrag in die Steuerelektronik reduziert wird und auf diese Weise negative Effekte auf die Steuerelektronik vermieden werden können.

Die Einrichtung zum Reduzieren des Wärmeeintrags in die Steuerelektronik dient dabei vornehmlich dazu, den von dem erwärmten Ventilkörper ausgehenden Wärmeeintrag zu reduzieren.

Mit anderen Worten kann auf diese Weise eine Vorrichtung zum Beeinflussen des Volumenstroms in kompakter Weise bereitgestellt werden und gleichzeitig eine Hitzeunempfindlichkeit erreicht werden, so dass die Vorrichtung zur Beeinflussung des Volumenstroms, beispielsweise ein Proportionalventil, besonders flexibel in Abfüllanlagen für Füllprodukte eingesetzt werden kann.

Durch die Einrichtung zum Reduzieren des Wärmeeintrags in die Steuerelektronik ist es weiterhin möglich, die Vorrichtung zum Beeinflussen des Volumenstroms auch mit Hochtemperatursterilisierungsverfahren und Hochtemperaturreinigungsverfahren zu reinigen bzw. zu sterilisieren. Die Vorrichtung kann entsprechend mit sämtlichen üblichen Abfüllverfahren und mit sämtlichen üblichen Reinigungs- und Sterilisierungsverfahren verwendet werden und stellt gleichzeitig dennoch einen besonders kompakten Aufbau bereit.

Vorteilhaft umfasst die Einrichtung zum Reduzieren des Wärmeeintrags Kühlrippen, welche an einem dem Gehäuse zugewendeten Ende des Ventilkörpers ausgebildet sind. Entsprechend kann ein Wärmefluss, der durch das Füllprodukt oder ein Sterilisationsmedium in den Ventilkörper eingetragen wird, in Richtung des Gehäuses reduziert werden. Ein Wärmefluss vom Ventilkörper in das Gehäuse kann entsprechend dadurch reduziert werden, dass ein Teil der über das Füllprodukt oder das Sterilisationsmedium in den Ventilkörper eingetragene Wärme über die Kühlrippen wieder an die Umgebung abgegeben wird, und entsprechend der Wärmefluss von dem Ventilkörper an das Gehäuse reduziert wird. Die Reduktion findet dabei zum einen dadurch statt, dass über die Kühlrippen Wärme an die Umgebung abgegeben wird, und zum anderen wird durch das Bereitstellen von Kühlrippen auch das Materialvolumen insgesamt reduziert, welches überhaupt zu einem Wärmetransport von dem Ventilkörper an das Gehäuse beitragen kann.

Die Kühlrippen im Ventilkörper können dabei entweder in dem Ventilkörper selbst angeordnet sein, welcher auch den Ventilsitz trägt und in welchem der Ventilkegel aufgenommen ist, oder können in einer Verlängerung des Ventilkörpers, welcher auch als separates, aber fest mit dem Ventilkörper verbundenen Element des Ventilkörpers vorgesehen sein kann, vorgesehen sein.

Die Kühlrippen sind bevorzugt in einem hygienischen Design ausgebildet. Entsprechend weisen die Kühlrippen keine Hinterschnitte, Falze oder harte Kanten auf, in welchen sich Fremdmaterial sammeln könnte. Bevorzugt ist eine Formung der Kühlrippen derart ausgebildet, dass Fremdmaterial während der Reinigung der Füllvorrichtung einfach mit einem Reinigungsmedium ausgespült bzw. entfernt werden kann.

In einer vorteilhaften Ausbildung umfasst die Einrichtung zum Reduzieren des Wärmeeintrags eine Pneumatikluftzufuhr zum Einbringen von Pneumatikluft in das Gehäuse. Besonders bevorzugt wird hier die ohnehin in einer Abfüllvorrichtung als Arbeitsmedium vorgesehene Pneumatikluft dazu verwendet, die im Gehäuse befindliche Wärme abzutransportieren.

Besonders bevorzugt weist die Pneumatikluftzufuhr ein Expansionsventil, ein Drosselventil oder eine Öffnung reduzierten Querschnitts zum Zuführen expandierter Pneumatikluft in das Gehäuse auf.

Die getrocknete und unter Überdruck stehende Pneumatikluft wird auf diese Weise bevorzugt beim Eintreten in das Gehäuse über das Expansionsventil, das Drosselventil oder die Öffnung reduzierten Querschnitts expandiert, so dass sie aufgrund des Joule-Thomson-Effekts abkühlt und entsprechend eine zusätzliche Kühlleistung zum Reduzieren des Wärmeeintrags in die Steuerelektronik bereitstellt.

In einer besonders bevorzugten Variante wird nicht nur das gesamte Gehäuseinnere von der Pneumatikluft durchströmt, sondern es findet ein gezieltes Beaufschlagen der Steuerelektronik durch die Pneumatikluft direkt nach deren Expansion im Gehäuse statt, so dass die Steuerelektronik gekühlt wird, bevor die dann immer noch kühle Pneumatikluft durch das restliche Gehäuse streicht.

Entsprechend sind das Gehäuse sowie die Pneumatikluftzufuhr geometrisch so ausgelegt, dass die Luftführung innerhalb des Gehäuses dafür sorgt, dass die expandierte und entsprechend kalte und trockene Pneumatikluft zunächst die Steuerelektronik bzw. andere temperaturempfindliche Bestandteile innerhalb des Gehäuses beaufschlagt und dann das restliche Gehäuse durchströmt und über einen Luftauslass das Gehäuse wieder verlässt.

Die Pneumatikluft wird dabei bevorzugt über definierte Kanäle aus dem Gehäuse nach außen abgeleitet, wobei über ein Auslassventil oder Rückschlagventil sichergestellt wird, dass beim Abschalten der Pneumatikluftzufuhr Feuchtigkeit und Fremdkörper nicht unkontrolliert in das Gehäuse eintreten.

Besonders bevorzugt ist die über die Pneumatikluftzufuhr vorgenommen Zufuhr von Pneumatikluft mittels eines Steuerventils anhand eines im Gehäuse vorgesehenen Temperatursensors geregelt oder gesteuert. Alternativ kann auch eine konstante Pneumatikluftzufuhr vorgenommen werden.

In einer besonders bevorzugten Variante wird die in das Gehäuse eingeleitete Pneumatikluft von dem Gehäuse durch den Ventilkörper, insbesondere durch den Aktuator, durch einen den Stößel des Ventilkegels gegenüber dem Füllprodukt abschirmenden Faltenbalg hindurch und dann über einen definierten Auslass in die Umgebung geleitet. Die Pneumatikluft kommt entsprechend nicht mit dem Füllprodukt in Berührung, dient jedoch sowohl zur Reduktion des Wärmeeintrags im Gehäuse und insbesondere an der Steuerelektronik und führt durch die Durchströmung des Aktuators auch zu einer Kühlung des Aktuators.

In einer vorteilhaften Ausgestaltung ist an dem Gehäuse ein Ventilblock angeordnet und bevorzugt der Aktuator des Ventils, besonders bevorzugt der Aktuator eines Vorsteuerventils, in dem Gehäuse aufgenommen.

Auf diese Weise kann auch ein Ventilblock, insbesondere ein Ventilblock mit Vorsteuerventilen zum weiteren Ansteuern vorgelagerter oder nachgelagerter Prozesse der Abfüllanlage mit der Vorrichtung zum Beeinflussen des Volumenstroms in kompakter Weise ausgebildet sein. Die Vorsteuerventile bzw. die Antriebe der Vorsteuerventile können dabei ebenfalls von dem Gehäuse aufgenommen sein, so dass auch die Antriebe der Vorsteuerventile durch die Einrichtung zum Reduzieren des Wärmeeintrags in die Steuerelektronik profitieren können.

Um einen kompakten Aufbau zu erreichen, kann das Gehäuse an einer Seite anstatt einer verschließenden Platte einen offenen Flansch aufweisen, an welchem der Ventilblock montiert werden kann. Bevorzugt ist eine Abdichtung zwischen Ventilblock und Gehäuse vorgesehen. Der Ventilblock kann aber auch zur Integration in das Gehäuse mit dem Gehäuse verschweißt werden.

Die Vorsteuerventile sowie zumindest deren Antriebe sind bevorzugt auch in dieser Ausführungsform in dem Gehäuse aufgenommen, um von der Einrichtung zum Reduzieren des Wärmeeintrags in die Steuerelektronik zu profitieren.

Eine besonders vorteilhafte Ausbildung ergibt sich, wenn der Ventilblock so ausgebildet ist, dass die Pneumatikabluft der Ventile, bevorzugt der Vorsteuerventile, in das Gehäuse geleitet wird. Mit anderen Worten entlüften die Vorsteuerventile auch in das Gehäuse, so dass beim Durchlaufen eines vollständigen Schaltzyklus beim Befüllen eines Behälters mit einem Füllprodukt und einer entsprechenden vollständigen Schaltung der Ventile und Vorsteuerventile durch die Abluft der Pneumatik ein Pneumatikluftstrom durch das Gehäuse hindurch bereitgestellt werden kann, welcher zur Reduktion des Wärmeeintrags in die Steuerelektronik dient.

Auf diese Weise ist es möglich, die sonst abgeführte, bereits verwendete Pneumatikluft noch zur Reduktion des Wärmeeintrags in die Steuerelektronik zu verwenden. Auf diese Weise kann auf eine separate Zufuhr von Pneumatikluft zur Reduktion des Wärmeeintrags in die Steuerelektronik verzichtet werden bzw. der Zufluss von Pneumatikluft zur Reduktion des Wärmeeintrags in die Steuerelektronik kann reduziert werden, so dass auf diese Weise insgesamt eine Reduktion des Verbrauchs an Pneumatikluft erreicht werden kann bei gleichzeitig sehr kompaktem Aufbau der Vorrichtung und Sicherstellen der Langlebigkeit bzw. Funktion der Schaltelektronik.

Um weiterhin einen kompakten Aufbau bereitzustellen und die Notwendigkeit für einen ausgelagerten, zentralen Elektronikkasten der Abfüllanlage weiter zu reduzieren, werden bevorzugt auch weitere Schnittstellen in das Gehäuse integriert, um beispielsweise Durchflussmesser, Wägezellen oder Kurzschlusssonden mit der Steuerelektronik so verbinden zu können, dass eine Regelung der Vorrichtung zur Beeinflussung des Volumenstroms auf Grundlage der entsprechenden Sensorsignale durchgeführt werden kann.

Dabei kann beispielsweise über einen Durchflusssensor die Stellung des Ventilstößels so geregelt werden, dass ein bestimmter, vorgesehener Durchfluss erreicht wird. Das Gleiche kann auch über das Signal einer Wägezelle bzw. das Signal einer Kurzschlusssonde erreicht werde, wobei über die Wägezelle der genaue Verlauf des Einfüllens des Füllprodukts in den zu befüllenden Behälter nachverfolgt werden kann, über eine Kurzschlusssonde hingegen nur das Erreichen eines bestimmten Füllgrads, welcher beispielsweise als Auslöser für eine Reduktion des Volumenstroms im letzten Füllabschnitt dienen kann.

Entsprechend kann die Elektronik, die vormals zentral angeordnet war, im Wesentlichen an die jeweilige Vorrichtung zum Beeinflussen des Volumenstroms verlagert werden, so dass die Vorrichtung insgesamt kompakter aufgebaut werden kann und die Notwendigkeit zur Verdrahtung reduziert werden kann.

### Kurze Beschreibung der Figuren

Bevorzugte weitere Ausführungsformen der Erfindung werden durch die nachfolgende Beschreibung der Figuren näher erläutert. Dabei zeigen:
- Figur 1: eine schematische, teilgeschnittene Seitenansicht eines Proportionalventils gemäß dem Stand der Technik;
- Figur 2: eine schematische, teilgeschnittene Seitenansicht einer Vorrichtung zum Beeinflussen des Volumenstroms eines Füllprodukts mit einer Einrichtung zum Reduzieren des Wärmeeintrags in die Steuerelektronik in Form von Kühlrippen;
- Figur 3: eine Detailansicht aus Figur 2, welche die Struktur der Kühlrippen zeigt;
- Figur 4: eine schematische, teilgeschnittene Seitenansicht einer weiteren Vorrichtung zum Beeinflussen des Volumenstroms eines Füllprodukts mit einer Einrichtung zum Reduzieren eines Wärmeeintrags in die Steuerelektronik in Form einer Pneumatikluftzufuhr;
- Figur 5: eine schematische, geschnittene Ansicht einer weiteren Vorrichtung zum Beeinflussen des Volumenstroms eines Füllprodukts mit einer Einrichtung zum Reduzieren eines Wärmeeintrags in die Steuerelektronik in Form einer Pneumatikluftzufuhr und mit einem integrierten Ventilblock;
- Figur 6: das Gehäuse aus Figur 5 in einer schematischen, teiltransparenten perspektivischen Darstellung; und
- Figur 7: eine schematische, teiltransparente perspektivische Darstellung des Gehäuses aus Figur 6 in Kombination mit der Vorrichtung zum Beeinflussen des Volumenstroms.

### Detaillierte Beschreibung bevorzugter Ausführungsbeispiele

Im Folgenden werden bevorzugte Ausführungsbeispiele anhand der Figuren beschrieben. Dabei werden gleiche, ähnliche oder gleichwirkende Elemente mit identischen Bezugszeichen bezeichnet. Um Redundanzen zu vermeiden, wird auf die wiederholte Beschreibung dieser Elemente in der nachfolgenden Beschreibung teilweise verzichtet.

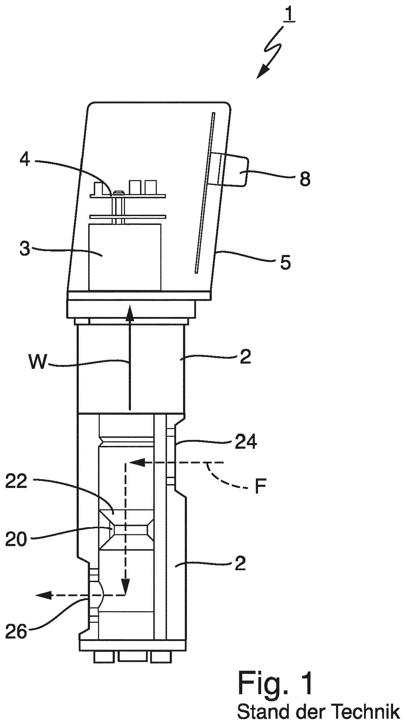

Figur 1 zeigt eine Vorrichtung 1 zum Beeinflussen des Volumenstroms eines Füllprodukts in einer Abfüllanlage zum Abfüllen von Füllprodukten gemäß dem Stand der Technik, beispielsweise zum Abfüllen von Getränken in einer Getränkeabfüllanlage.

Die Vorrichtung 1 umfasst einen Ventilkörper 2, welcher einen Ventilsitz 20 definiert, der in Kommunikation mit einem Zulauf 24 und einem Ablauf 26 für das Füllprodukt steht. In dem Ventilkörper 2 ist ein Ventilkegel 22 aufgenommen, der in den Ventilsitz 22 dichtend beziehungsweise teildichtend abgesenkt und aus dem Ventilsitz 20 wieder herausgehoben werden kann, so dass der Volumenstrom des Füllprodukts, welches über den Zulauf 24 in den Ventilkörper 2 und in den den Ventilsitz 22 ausbildenden Hohlraum eintritt, durch den Ringspalt zwischen Ventilsitz 20 und Ventilkegel 22 strömt und dann über den Auslauf 26 den Ventilkörper 2 wieder verlässt. Der Fließweg des Füllprodukts durch die Vorrichtung 1 hindurch ist in der Figur 1 schematisch durch den Pfeil F dargestellt.

Durch die Positionierung des Ventilkegels 22 relativ zum Ventilkegel 20 kann der durch die Vorrichtung 1 strömende Volumenstrom des Füllprodukts gesteuert bzw. geregelt werden. Ist beispielsweise der Ventilkegel 22 vollständig aus dem Ventilsitz 20 herausgehoben, so strömt das Füllprodukt ungehindert aus dem Auslauf 26 heraus und eine Drosselung des Volumenstroms - abgesehen von dem durch die Vorrichtung 1 ohnehin vorgegebenen Fließwiderstand - findet nicht statt. Ist eine Drosselung des Volumenstroms des Füllprodukts erwünscht, so kann der Ventilkegel 22 in Richtung des Ventilsitzes 20 um einen entsprechenden Betrag abgesenkt werden, um den Ringspalt zwischen Ventilkegel 22 und Ventilsitz 20 zu reduzieren und damit den gewünschten reduzierten Volumenstrom zu erreichen.

Um die entsprechende Positionierung des Ventilkegels 22 relativ zum Ventilsitz 20 zu erreichen, ist ein Aktuator 3 vorgesehen, welcher beispielsweise in Form eines Elektromotors oder eines anderen elektromechanischen Antriebs vorgesehen sein kann, welcher mit dem Ventilkegel 22 beispielsweise über einen Stößel mechanisch so gekoppelt ist, dass bei einer Betätigung des Aktuators 3 eine entsprechende Positionierung des Ventilkegels 22 relativ zum Ventilsitz 20 erreicht werden kann.

Zur Ansteuerung des Aktuators 3 ist eine Steuerelektronik 4 vorgesehen, welche eine Ansteuerung des Aktuators 3 auf Grundlage externer Steuersignale, auf Grundlage einer durch die Steuerelektronik 4 selbst bereitgestellten Logik oder auf Grundlage einer Kombination beider Möglichkeiten ermöglicht. Die Steuerelektronik 4 kann je nach deren Ausbildung unterschiedliche externe Steuersignale verarbeiten, Sensorsignale auswerten und verarbeiten und/oder Rückmeldungen des Aktuators 3 verarbeiten, um schlussendlich eine Positionierung des Ventilkegels 22 relativ zum Ventilsitz 20 und damit einen Volumenstrom gemäß den Vorgaben des Füllverfahrens bzw. den Vorgaben einer zentralen Abfüllsteuerung zu erreichen.

Der Aktuator 3 sowie die Steuerelektronik 4 sind in einem Gehäuse 5 aufgenommen, das direkt mit dem Ventilkörper 2 verbunden ist und gemäß der bekannten Ausführung dichtend mit dem Ventilkörper 2 abschließt. Durch die Aufnahme des Aktuators 3 und der Steuerelektronik 4 in dem direkt am Ventilkörper 2 angebrachten Gehäuse 5 ist es möglich, die Vorrichtung 1 kompakt auszubilden und eine hygienisch einwandfreie Gestaltung zu ermöglichen.

Würde nun in dieser Vorrichtung 1 aus Figur 1, welche gemäß dem Stand der Technik ausgebildet ist, ein heißes Füllprodukt den Ventilkörper 2 durchfließen, so fände ein Wärmefluss von dem Ventilkörper 2 in das Gehäuse 5 statt, so dass im Gehäuse 5 eine erhöhte Temperatur auftäte, welche unter Umständen die Funktionsfähigkeit und Dauerhaltbarkeit der Steuerelektronik 4 negativ beeinflussen könnte. Der Wärmefluss vom Ventilkörper 2 zum Gehäuse 5 ist in der Figur schematisch durch den Pfeil W dargestellt. Die Vorrichtung 1 aus der Figur 1 gemäß dem Stand der Technik ist entsprechend nicht vorteilhaft in Abfüllverfahren einsetzbar, bei denen der Ventilkörper 2 von einem heißen Füllprodukt durchflossen wird.

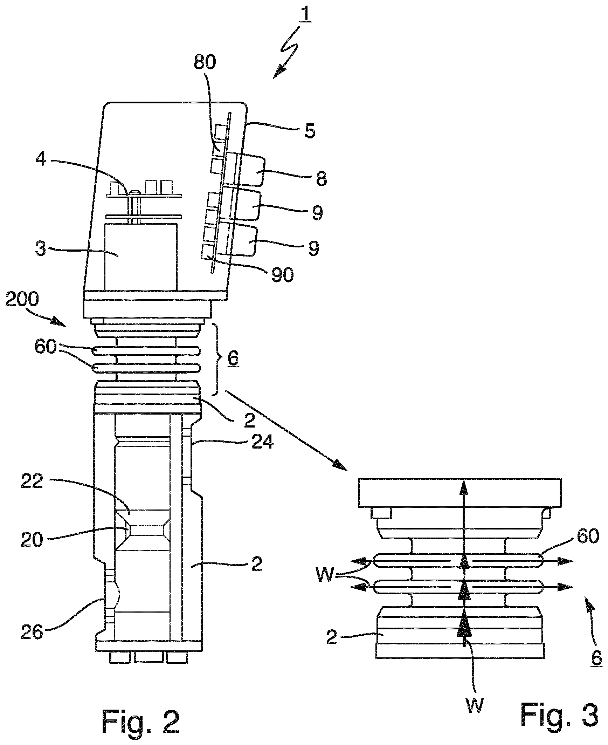

In Figur 2 ist nun eine Vorrichtung 1 gemäß der vorliegenden Ausbildung gezeigt, bei welcher der Ventilkörper 2 eine Einrichtung 6 zum Reduzieren des Wärmeeintrags in die Steuerelektronik 4 in Form von Kühlrippen 60 aufweist. Die Einrichtung 6 zum Reduzieren des Wärmeeintrags in die Steuerelektronik 4 dient besonders zur Reduktion des Wärmeeintrags, der von dem Ventilkörper 2 ausgeht, in die Steuerelektronik 4.

Durch die Bereitstellung der Kühlrippen 60 wird, wenn ein heißes Füllprodukt den Ventilkörper 2 durchströmt, der Wärmestrom, welcher von dem Ventilkörper 2 zum Gehäuse 5 fließt, reduziert. Entsprechend wird auch der Wärmeeintrag in die Steuerelektronik 4 reduziert.

Die Einrichtung 6 zum Reduzieren des Wärmeeintrags in die Steuerelektronik 4 ermöglicht es entsprechend, die Vorrichtung 1 zum Beeinflussen des Volumenstroms auch für heiße Füllprodukte zu verwenden. Damit kann die Vorrichtung 1 nun in allen üblichen Abfüllverfahren eingesetzt werden, so dass ein kompakter Aufbau einer universell einsetzbaren Abfüllanlage erreicht werden kann.

Die Einrichtung zum Reduzieren des Wärmeeintrags 6 in Form der Kühlrippen 60 ist dabei bevorzugt so ausgebildet, dass ein möglichst großer Anteil der von dem Ventilkörper 2 in Richtung des Gehäuses 5 fließenden Wärmeenergie bereits mittels der Kühlrippen 60 abgestrahlt wird und entsprechend nicht in das Gehäuse 5 fließt. Der Fluss der Wärme und die Abstrahlung der Wärmeenergie aufgrund der Kühlrippen 60 ist in der Detaildarstellung der Kühlrippen 60 in Figur 3 schematisch durch die Pfeile W dargestellt. Die Kühlrippen 60 sind dazu entsprechend an demjenigen Ende 200 des Ventilkörpers 2 vorgesehen, an welches sich das Gehäuse 5 anschließt. Die Kühlrippen 60 stellen damit quasi eine Teilisolierung zwischen dem Ventilkörper 2 und dem Gehäuse 5 bereit.

Die Kühlrippen 60 sind, wie beispielsweise auch aus der Detaildarstellung der Figur 3 zu erkennen, bevorzugt so ausgebildet, dass Hinterschnitte und Kanten, in denen sich Fremdmaterial ansammeln könnte, vermieden werden. Auf diese Weise kann entsprechend ein hygienisches Design bereitgestellt werden, welches gerade im Bereich der Abfüllung von Lebensmitteln und Getränken von Bedeutung ist. Die Oberflächen der Kühlrippen 60 sind entsprechend glatt und die Formgestaltung ist so abgerundet ausgeprägt, dass sich Fremdmaterial nicht festsetzen kann und während eines Reinigungszyklus zuverlässig und einfach ausgespült werden kann.

In dem Gehäuse 5 können neben dem Aktuator 3 und den Aktuatoren des Ventilblocks 7 bzw. der Vorsteuerventile 74 auch weitere Elektronikbausteine 90 zur Auswertung von über eine zusätzliche Sensorschnittstelle 9 zugeführten Sensorsignalen vorgesehen sein. Weiterhin können auch Kommunikationsmodule 80 zum Anbinden der Vorrichtung 1 an eine übergeordnete Steuerung, beispielsweise an die Anlagensteuerung, vorgesehen sein. Auch diese Komponenten können von der bevorzugten Ausgestaltung des reduzierten Wärmeeintrags profitieren und ermöglichen gleichzeitig, dass ein besonders kompakter Aufbau der Vorrichtung 1 und damit der ganzen Abfüllanlage ermöglicht wird.

Für die Sensorschnittstelle 9 ist es bevorzugt, eine Anbindung an einen Durchflussmesser zu ermöglichen, mittels welchem dann die Position des Ventilkegels 22 gegenüber dem Ventilsitz 20 nach entsprechenden Vorgaben für den Volumenstrom geregelt werden kann. Als Variante kann auch eine Anbindung an eine Wägezelle vorgesehen sein, mittels welcher der in den zu befüllenden Behälter einströmende Volumenstrom ermittelt werden kann und hierüber entsprechend die Position des Ventilkegels 22 relativ zum Ventilsitz 20 geregelt werden kann.

Weiterhin kann die Sensorschnittstelle 9 auch zur Anbindung einer Kurschlusssonde vorgesehen sein, welche in den zu befüllenden Behälter eintaucht, um eine bestimmte Füllschwelle zu signalisieren, ab welcher eine Veränderung des in den Behälter einfließenden Volumenstroms vorgenommen werden soll, beispielsweise zum Ende des Füllvorgangs hin.

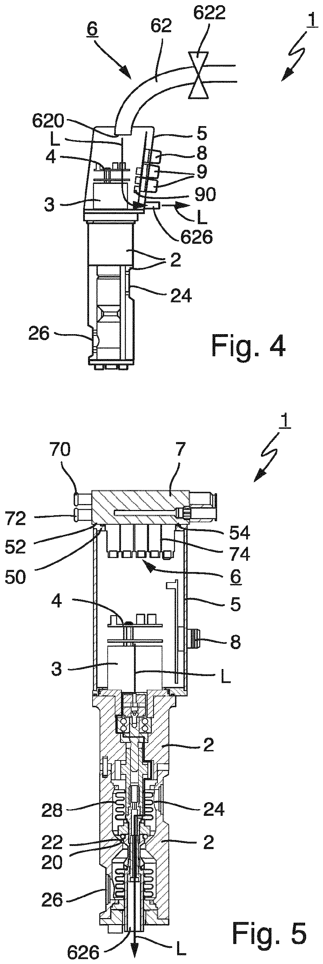

In einer weiteren Ausbildung der Vorrichtung 1, so wie sie in Figur 4 gezeigt ist, ist an dem Gehäuse 5 eine Einrichtung zum Reduzieren des Wärmeeintrags 6 in Form einer Pneumatikluftzufuhr 62 vorgesehen. Über die Pneumatikluftzufuhr 62 kann Pneumatikluft, die in einer Abfüllanlage zum Abfüllen des Füllprodukts ohnehin als Arbeitsmedium vorgesehen ist, in das Gehäuse 5 eingebracht werden und auf diese Weise ein Abtransport von Wärme stattfinden, so dass auch hier eine Reduktion des Wärmeeintrags in die Steuerelektronik 4 erreicht wird.

Um ein stetes Durchströmen des Gehäuses 5 mit Pneumatikluft zu ermöglichen, ist weiterhin bevorzugt ein Luftauslass 626 vorgesehen, welcher so angeordnet ist, dass die über die Pneumatikluftzufuhr 62 zugeführte Pneumatikluft das Gehäuse 5 gleichmäßig und bevorzugt auch abhängig von der Temperaturempfindlichkeit der jeweiligen Bausteine innerhalb des Gehäuses 5 durchstreicht. Der Luftauslass 626 ist bevorzugt mit einem Rückschlagventil versehen, so dass bei einem Abschalten der Pneumatikluftzufuhr 62 das Eintreten von Fremdkörpern und Feuchtigkeit in das Gehäuse 5 unterbunden wird. Der Luftfluss der Pneumatikluft durch das Gehäuse 5 hindurch und an der Schaltelektronik 4 vorbei ist in der Figur schematisch durch den Pfeil L angedeutet.

Die Pneumatikluftzufuhr 62 in das Gehäuse 5 kann bevorzugt über ein Expansionsventil, ein Drosselventil oder eine Öffnung reduzierten Querschnitts 620 vorgenommen werden, derart, dass eine Expansion der zugeführten und unter Druck stehenden, getrockneten Pneumatikluft aus dem Pneumatiksystem der Abfüllanlage stattfindet und die Pneumatikluft beim Eintritt in das Gehäuse 5 entsprechend herabgekühlt wird. Neben der Zufuhr bzw. dem Durchströmen des Gehäuses 5 mit Pneumatikluft zum Abtransport von Wärme wird entsprechend durch den Joule-Thomson-Effekt an dieser Stelle auch explizit noch eine Kühlung bereitgestellt, welche ebenfalls zum Reduzieren des Wärmeeintrags in die Steuerelektronik 4 dient.

Die Pneumatikluftzufuhr 62 und insbesondere die Ausrichtung der Öffnung reduzierten Querschnitts 620 ist dabei so gewählt, dass die expandierte, getrocknete und durch die Expansion abgekühlte Pneumatikluft zunächst auf die besonders temperaturempfindlichen Bauteile innerhalb des Gehäuses 6 auftrifft, insbesondere auf die Steuerelektronik 4, so dass auf diese Weise eine Kühlung und damit eine Reduktion des Wärmeeintrags in die Steuerelektronik 4 erreicht wird.

Über ein Steuerventil 622 kann die Zufuhr von Pneumatikluft über die Pneumatikluftzufuhr 62 gesteuert bzw. geregelt werden. Dabei kann entweder eine konstante Pneumatikluftmenge bereitgestellt werden und durch das Gehäuse 5 hindurchstreichen, um entsprechend die Reduktion des Wärmeeintrags in die Steuerelektronik 4 zu erreichen. Es kann aber auch mittels eines im Gehäuse 5 vorgesehenen Temperatursensors 624 über eine Steuerung oder Regelung der Zufuhr der Menge an Pneumatikluft vorgenommen werden. Dabei kann beispielsweise beim Überschreiten bestimmter Temperaturschwellwerte die Zufuhr von Pneumatikluft mittels des Steuerventils 622 erhöht und bei Unterschreiten bestimmter Temperaturschwellwerte die Zufuhr von Pneumatikluft reduziert werden. Der Temperatursensor 624 kann bevorzugt auch direkt auf der Platine der Steuerelektronik 4 vorgesehen sein, um die Temperatur der Steuerelektronik 4 direkt zu überwachen.

Durch eine Steuerung oder Regelung der Zufuhr der Pneumatikluft kann der Verbrauch an Pneumatikluft optimiert werden und gleichzeitig aber dafür gesorgt werden, dass die Steuerelektronik 4 stets in einem optimierten Temperaturbereich betrieben wird und damit der Wärmeeintrag in die Steuerelektronik 4 reduziert wird.

In Figur 5 ist schematisch eine Schnittdarstellung einer Vorrichtung 1 in einer weiteren Ausführung gezeigt, bei der das Gehäuse 5 an seiner Oberseite 50 mit einem Flansch 52 versehen ist. Auf dem Flansch 52 ist, bevorzugt unter Verwendung einer Dichtung 54, ein Ventilblock 7 aufgesetzt, welcher das Gehäuse 5 dann nach oben hin verschließt. Der Ventilblock 7 kann anstelle der Verschraubung mittels des Flansches 52 auch direkt mit dem Gehäuse 5 verschweißt werden.

Der Ventilblock 7 umfasst neben einer Pneumatikluftzufuhr 70 und einer Pneumatikluftabfuhr 72 auch mehrere Vorsteuerventile 74. Die Vorsteuerventile 74 sind zum Schalten unterschiedlicher pneumatischer Vorgänge innerhalb der Abfüllanlage vorgesehen. Durch das Aufbringen des Ventilblocks 7 quasi als obere "Gehäusewand" des Gehäuses 5 an dessen Oberseite 50 und das Verschrauben mit dem Flansch 52, bevorzugt unter Verwendung einer Dichtung 54, kann das Gehäuse 5 gegenüber der Umgebung abgedichtet werden und die Vorsteuerventile 74 bzw. deren Antriebe können in den Innenraum des Gehäuses 5 hereinragen. Auf diese Weise ergibt sich eine sehr kompakte Ausbildung der Vorrichtung 1 in Kombination mit dem Ventilblock 7 und die Vorsteuerventile 74 bzw. die Antriebe der Vorsteuerventile 74 können ebenfalls durch die Einrichtung 6 zum Reduzieren des Wärmeeintrags in die Steuerelektronik 4 von dem reduzierten Wärmeeintrag profitieren. Mit anderen Worten können auch die Vorsteuerventile 74 bzw. deren Aktuatoren innerhalb des Gehäuses 5 gekühlt werden, bei einem gleichzeitig kompakten Aufbau der Vorrichtung 1.

Besonders bevorzugt ist es dabei, wenn die Vorsteuerventile 74 in das Gehäuse 5 hinein entlüften. Auch die Pneumatikluftabfuhr 72 kann in das Gehäuse 5 hinein geleitet werden. Auf diese Weise kann eine Reduzierung des Eintrags an Wärmeenergie in die Schaltelektronik 4 dadurch erreicht werden, dass die bereits im Ventilblock 7 verwendete Pneumatikluft in das Gehäuse 5 herein expandiert wird und auf diese Weise für die im Gehäuse 5 vorgesehenen Komponenten und insbesondere für die Schaltelektronik 4 zu einer Reduktion des Wärmeeintrags führt und für einen Abtransport der Wärmeenergie sorgt. Dadurch, dass die ohnehin vorhandene Abluft aus dem Ventilblock 7 verwendet wird, kann die Verwendung zusätzlicher Pneumatikluft eingespart werden.

Bevorzugt fließt die Pneumatikluft durch das Gehäuse 5 und durch den Aktuator 3, also zwischen Rotor und Stator des Aktuators 3, hindurch, und dann durch einen Faltenbalg 28, welcher zur Abdichtung des Aktuators 3 gegenüber dem Füllprodukt vorgesehen ist, hindurch, um dann über eine den Ventilkegel 22 fixierende und entsprechend als Luftauslass 626 ausgebildete Schraube aus der Vorrichtung 1 abgeleitet zu werden. Der Luftfluss ist durch den Pfeil L angedeutet. Entsprechend durchströmt die Pneumatikluft nicht nur das Innere des Gehäuses 5, sondern auch den Aktuator 3 und Teile des Ventilkörpers 2, um auf diese Weise einen Abtransport von Wärmeenergie zu ermöglichen.

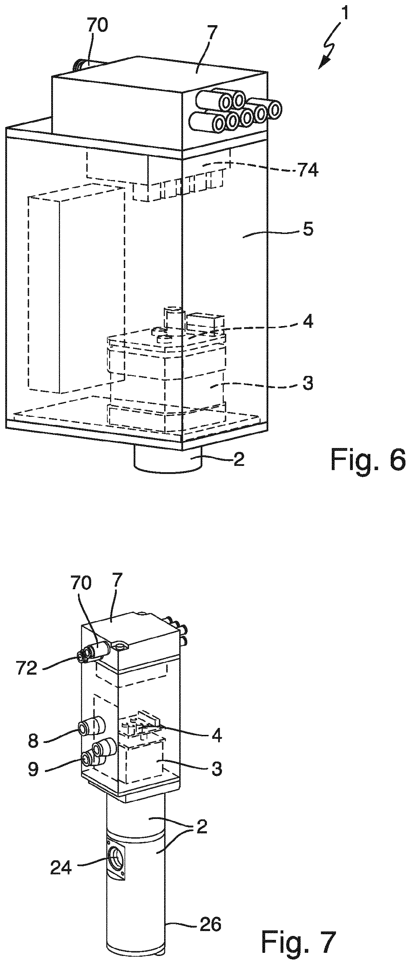

In den Figuren 6 und 7 wird der zu Figur 5 beschriebene Aufbau noch einmal schematisch in perspektivischen Darstellungen gezeigt.

Die Innenseiten des Gehäuses 5 können weiterhin auch mit einer schwarzen Beschichtung versehen sein, um eine erhöhte Wärmeabsorption zu ermöglichen und entsprechend einen Abtransport der in das Gehäuse eingetragenen Wärmeenergie nach außen hin zu ermöglichen.

Weiterhin kann auch durch eine verbesserte Wärmeübertragung der vom Aktuator 3 erzeugten Wärmeenergie an die Wand des Gehäuses 5 erreicht werden, dass die über den Aktuator 3 in das Innere des Gehäuses 5 eingetragene Wärmeenergie über die Gehäusewand nach außen hin abtransportiert und abgestrahlt wird. Eine verbesserte Wärmeleitung kann beispielsweise über direkte metallische Verbindungen, Wärmeleitpads, Wärmeleitpaste oder eine entsprechende konstruktive Einrückung der Gehäusewand zum Aktuator 3 hin erreicht werden.

Weiterhin kann auch die von dem Aktuator 3 eingetragene Wärmeenergie dadurch reduziert werden, dass der Aktuator 3 auf Grundlage des tatsächlich benötigten Drehmoments gesteuert wird, da üblicherweise die Faltenbälge 28 bei höheren Temperaturen weniger steif sind und entsprechend ein geringeres Drehmoment benötigt wird, so dass der Aktuator 3 dann mit weniger Energie betrieben werden kann und entsprechend weniger Wärme in den Innenraum des Gehäuses 5 einträgt.

### Bezugszeichenliste

- 1: Vorrichtung zum Beeinflussen des Volumenstroms
- 100: Abfüllanlage zum Abfüllen eines Füllprodukts in einen Behälter
- 110: Füllventil zum Befüllen eines Behälters mit einem Füllprodukt
- 2: Ventilkörper
- 20: Ventilsitz
- 22: Ventilkegel
- 24: Zulauf
- 26: Ablauf
- 28: Faltenbalg
- 200: dem Gehäuse zugewendetes Ende des Ventilkörpers
- 3: Aktuator
- 4: Steuerelektronik
- 5: Gehäuse
- 50: Oberseite
- 52: Flansch
- 54: Dichtung
- 6: Einrichtung zum Reduzieren des Wärmeeintrags in die Steuerelektronik
- 60: Kühlrippen
- 62: Pneumatikluftzufuhr
- 620: Öffnung reduzierten Querschnitts
- 622: Steuerventil
- 624: Temperatursensor
- 626: Luftauslass
- 7: Ventilblock
- 70: Pneumatikluftzufuhr
- 72: Pneumatikluftabfuhr
- 74: Vorsteuerventil
- 8: Anschluss für externe Steuerung
- 80: Kommunikationsmodul
- 9: Anschluss für weitere Sensoren
- 90: Sensorelektronik
- F: Füllproduktstrom
- W: Wärmestrom
- L: Luftstrom

## Patentansprüche

1. Vorrichtung (1) zum Beeinflussen des Volumenstroms eines Füllprodukts in einer Abfüllanlage (100) zum Abfüllen von Füllprodukten, umfassend einen Ventilkörper (2) mit einem Ventilsitz (20) und einen relativ zu diesem bewegbaren Ventilkegel (22), einen Aktuator (3) zum Positionieren des Ventilkegels (22) bezüglich des Ventilsitzes (20), eine Steuerelektronik (4) zum Ansteuern des Aktuators (3), ein Gehäuse (5), welches direkt mit dem Ventilkörper (2) verbunden ist und in welchem der Aktuator (3) und die Steuerelektronik (4) angeordnet sind, sowie eine Einrichtung (6) zum Reduzieren eines Wärmeeintrags in die Steuerelektronik (4)
**dadurch gekennzeichnet,**
**dass** die Einrichtung (6) zum Reduzieren des Wärmeeintrags Kühlrippen (60) umfasst, welche an einem dem Gehäuse (5) zugewendeten Ende (200) des Ventilkörpers (2) ausgebildet sind, und/oder dass die Einrichtung (6) zum Reduzieren des Wärmeeintrags eine Pneumatikluftzufuhr (62) zum Einbringen von Pneumatikluft in das Gehäuse (5) umfasst.

2. Vorrichtung (1) gemäß Anspruch 1, **dadurch gekennzeichnet, dass** die Kühlrippen (60) in einem hygienischen Design ausgebildet sind.

3. Vorrichtung (1) gemäß Anspruch 1 oder 2, **dadurch gekennzeichnet, dass** die Pneumatikluftzufuhr (62) ein Expansionsventil, ein Drosselventil oder eine Öffnung reduzierten Querschnitts (620) zum Zuführen expandierter Pneumatikluft in das Gehäuse (5) aufweist.

4. Vorrichtung (1) gemäß einem der vorstehenden Ansprüche, **dadurch gekennzeichnet, dass** die Pneumatikluftzufuhr (62) so angeordnet ist, dass der austretende Pneumatikluftstrom (L) auf die Steuerelektronik (4) trifft.

5. Vorrichtung (1) gemäß einem der vorstehenden Ansprüche, **dadurch gekennzeichnet, dass** die über die Pneumatikluftzufuhr (62) vorgenommen Zufuhr an Pneumatikluft mittels eines Steuerventils (622) anhand eines im Gehäuse (5) vorgesehenen Temperatursensors (624) geregelt ist.

6. Vorrichtung (1) gemäß einem der vorstehenden Ansprüche, **dadurch gekennzeichnet, dass** das Gehäuse (5) einen Luftauslass (626) aufweist, welcher bevorzugt mit einem Rückschlagventil versehen ist.

7. Vorrichtung (1) gemäß einem der vorstehenden Ansprüche, **dadurch gekennzeichnet, dass** an dem Gehäuse (5) ein Ventilblock (7) angeordnet ist und bevorzugt der Aktuator des Ventils, besonders bevorzugt der Aktuator eines Vorsteuerventils (74), in dem Gehäuse (5) aufgenommen ist.

8. Vorrichtung (1) gemäß Anspruch 7
**dadurch gekennzeichnet, dass** der Ventilblock (7)
eine Wand des Gehäuses (5) ausbildet und bevorzugt mittels eines am Gehäuse (5) vorgesehenen Flanschs (52) mit dem Gehäuse (5) verbunden ist.

9. Vorrichtung (1) gemäß Anspruch 7 oder 8
**dadurch gekennzeichnet, dass** der
Ventilblock (7) so ausgebildet ist, dass die Pneumatikabluft der Ventile, bevorzugt der Vorsteuerventile (74), in das Gehäuse (5) geleitet wird.

10. Vorrichtung (1) gemäß einem der vorstehenden Ansprüche, **dadurch gekennzeichnet, dass** an dem Gehäuse (5) Sensorschnittstellen (9) zum Anschluss eines Durchflussmessers, einer Wägezelle und/oder eines Kurzschlusssensors vorgesehen sind und im Gehäuse (5) bevorzugt eine Sensorelektronik (90) aufgenommen ist.

## Claims

1. Device (1) for influencing the volume flow of a filling product in a filling plant (100) for filling filling products, comprising a valve body (2) having a valve seat (20) and a valve plug (22) movable relative thereto, an actuator (3) for positioning the valve plug (22) with respect to the valve seat (20), a control electronics system (4) for controlling the actuator (3), a housing (5) which is directly connected to the valve body (2) and in which the actuator (3) and the control electronics system (4) are arranged, as well as an apparatus (6) for reducing heat influx into the control electronics system (4),
**characterised in**
**that** the apparatus (6) for reducing the heat influx comprises cooling ribs (60) which are formed on an end (200) of the valve body (2) which faces the housing (5), and/or that the apparatus (6) for reducing the heat influx comprises a pneumatic air supply (62) for introducing pneumatic air into the housing (5).

2. Device (1) according to claim 1, **characterised in that** the cooling ribs (60) are formed in a hygienic design.

3. Device (1) according to claim 1 or 2, **characterised in that** the pneumatic air supply (62) has an expansion valve, a throttle valve or an opening of reduced cross-section (620) for supplying expanded pneumatic air into the housing (5).

4. Device (1) according to any of the preceding claims, **characterised in that** the pneumatic air supply (62) is arranged such that the emerging pneumatic air flow (L) impacts on the control electronics system (4).

5. Device (1) according to any of the preceding claims, **characterised in that** the supply of pneumatic air undertaken via the pneumatic air supply (62) is regulated by means of a control valve (622) with a temperature sensor (624) provided in the housing (5).

6. Device (1) according to any of the preceding claims, **characterised in that** the housing (5) has an air outlet (626) which is preferably equipped with a non-return valve.

7. Device (1) according to any of the preceding claims, **characterised in that** a valve block (7) is arranged on the housing (5) and preferably the actuator of the valve, particularly preferably the actuator of a pilot valve (74) is accommodated in the housing (5).

8. Device (1) according to claim 7 **characterised in that** the valve block (7) forms a wall of the housing (5) and is preferably connected to the housing (5) by means of a flange (52) provided on the housing (5).

9. Device (1) according to claim 7 or 8 **characterised in that** the valve block (7) is designed such that the pneumatic waste air of the valves, preferably of the pilot valves (74) is guided into the housing (5).

10. Device (1) according to any of the preceding claims **characterised in that** sensor interfaces (9) for connecting a throughflow meter, a load cell and/or a short-circuit sensor are provided on the housing (5) and a sensor electronics system (90) is preferably accommodated in the housing (5).

## Revendications

1. Dispositif (1) pour agir sur le flux volumique d'un produit de remplissage dans une installation de mise en bouteille (100) pour la mise en bouteille de produits de remplissage, comprenant un corps de soupape (2) doté d'un siège de soupape (20) et un cône de soupape (22) mobile par rapport à celui-ci, un actionneur (3) pour positionner le cône de soupape (22) par référence au siège de soupape (20), une électronique de commande (4) pour commander l'actionneur (3), un boîtier (5) qui est relié directement au corps de soupape (2) et dans lequel sont agencés l'actionneur (3) et l'électronique de commande (4), ainsi qu'un appareil (6) pour réduire une pénétration de chaleur dans l'électronique de commande (4);
**caractérisé en ce que**
l'appareil (6) pour réduire la pénétration de chaleur comprend des ailettes de refroidissement (60) qui sont formées au niveau d'une extrémité (200) du corps de soupape (2) tournée vers le boîtier (5), et/ou **en ce que** l'appareil (6) pour réduire la pénétration de chaleur comprend une alimentation en air pneumatique (62) pour introduire de l'air pneumatique dans le boîtier (5).

2. Dispositif (1) selon la revendication 1, **caractérisé en ce que** les ailettes de refroidissement (60) sont formées selon une conception hygiénique.

3. Dispositif (1) selon la revendication 1 ou 2, **caractérisé en ce que** l'alimentation en air pneumatique (62) présente une soupape de détente, une soupape d'étranglement ou une ouverture de section transversale réduite (620) pour alimenter de l'air pneumatique détendu par expansion dans le boîtier (5).

4. Dispositif (1) selon l'une quelconque des revendications précédentes, **caractérisé en ce que** l'alimentation en air pneumatique (62) est agencée de telle manière que le flux d'air pneumatique sortant (L) rencontre l'électronique de commande (4).

5. Dispositif (1) selon l'une quelconque des revendications précédentes, **caractérisé en ce que** l'air pneumatique alimenté apporté via l'alimentation en air pneumatique (62) est régulée au moyen d'une soupape de commande (622) à l'aide d'un capteur de température (624) prévu dans le boîtier (5).

6. Dispositif (1) selon l'une quelconque des revendications précédentes, **caractérisé en ce que** le boîtier (5) présente une sortie d'air (626), qui est de préférence munie d'un clapet anti-retour.

7. Dispositif (1) selon l'une quelconque des revendications précédentes, **caractérisé en ce qu'**un bloc de soupapes (7) est agencé au niveau du boîtier (5) et de préférence l'actionneur de la soupape, le plus préférentiellement l'actionneur d'une soupape pilote (74) est reçu dans le boîtier (5).

8. Dispositif (1) selon la revendication 7 **caractérisé en ce que** le bloc de soupapes (7) forme une paroi du boîtier (5) et est de préférence relié au boîtier (5) au moyen d'une bride (52) prévue au niveau du boîtier (5).

9. Dispositif (1) selon la revendication 7 ou 8 **caractérisé en ce que** le bloc de soupapes (7) est conçu de sorte que l'échappement d'air pneumatique des soupapes, de préférence des soupapes pilotes (74), est dirigé dans le boîtier (5).

10. Dispositif (1) selon l'une quelconque des revendications précédentes, **caractérisé en ce que** des interfaces de capteur (9) pour connecter un débitmètre, une cellule de charge et/ou un capteur de court-circuit sont prévues au niveau du boîtier (5) et une électronique de capteur (90) est de préférence reçue dans le boîtier (5).
